# FASCICULE DE BREVET EUROPEEN

(11) **EP 3 766 830 B1**
(45) Date de publication et mention de la délivrance du brevet: **29.11.2023**
(21) Numéro de dépôt: 20185353.8
(22) Date de dépôt: 10.07.2020
(51) Int. Cl.: B81B 3/00

(54) **LIAISON MECANIQUE POUR STRUCTURE MECANIQUE MEMS ET NEMS, ET STRUCTURE MEMS ET NEMS COMPRENANT UNE TELLE LIAISON MECANIQUE**
MECHANISCHE VERBINDUNG FÜR MECHANISCHE MEMS- UND NEMS-STRUKTUR, UND MEMS- UND NEMS-STRUKTUR, DIE EINE SOLCHE MECHANISCHE VERBINDUNG UMFASST
MECHANICAL LINK FOR MECHANICAL MEMS AND NEMS STRUCTURE, AND MEMS AND NEMS STRUCTURE COMPRISING SUCH A MECHANICAL LINK

(30) Priorité: 18.07.2019 FR 1908130
(43) Date de publication de la demande: 20.01.2021
(73) Titulaire: Commissariat à l'Energie Atomique et aux Energies Alternatives, 75015 Paris (FR)
(72) Inventeur: JOET, Loïc, 38054 Grenoble Cedex 09 (FR); REY, Patrice, 38054 Grenoble Cedex 09 (FR); VERDOT, Thierry, 38054 Grenoble Cedex 09 (FR)
(74) Mandataire: Atout PI Laplace

(56) Documents cités:
- FR-A1- 2 977 319

## Description

### Domaine technique de l'invention

La présente invention se situe dans le domaine des structures et des capteurs utilisant les technologies « MEMS » (MicroElectroMechanical Systems) et/ou « NEMS » (NanoElectroMechanical Systems). Les structures et les capteurs utilisant les deux technologies seront désignés dans l'ensemble de la description par « structures MEMS-NEMS » et « capteurs MEMS-NEMS ».

Plus précisément, l'invention concerne une liaison mécanique pour des structures MEMS-NEMS ou des capteurs MEMS-NEMS qui utilisent la détection d'un mouvement (déplacement ou déformation) d'une pièce mobile par rapport à une pièce fixe (généralement un substrat), ledit mouvement étant transmis à un détecteur (jauge de contrainte, capacité, résonateur ...) qui permet de le mesurer.

De tels capteurs MEMS-NEMS peuvent être par exemple des gyromètres, des accéléromètres, des capteurs de pression, des magnétomètres, des microphones ....

### Etat de la technique

Dans le domaine des capteurs MEMS-NEMS, il existe des capteurs basés sur un système de bras de levier, dont le principe est de transmettre une force amplifiée par le bras de levier à un détecteur qui permet de le mesurer. Le bras de levier est connecté au détecteur et d'autre part il est relié à une partie mobile (ou il est une pièce mobile d'une partie mobile) dont on cherche à mesurer le mouvement. Le bras de levier est connecté au détecteur de mouvement généralement par l'intermédiaire d'une liaison pivot, par exemple une charnière. Un tel système de bras de levier permet en outre de réaliser une mesure différentielle. Pour cela on utilise deux détecteurs de mouvement, disposés judicieusement par rapport à l'axe de rotation du bras de levier.

Le mouvement à mesurer peut être en dehors du plan du substrat. Dans ce cas, on parle de mouvement « hors-plan ». Le mouvement à mesurer peut alternativement être dans le plan du substrat.

Dans le cas du hors-plan, le bras de levier peut permettre avantageusement de transformer un mouvement de rotation hors-plan en un mouvement de rotation dans le plan mesuré par le détecteur de mouvement, comme décrit par exemple dans la demande de brevet FR2941533 qui concerne un capteur de type accéléromètre permettant de détecter un effort hors-plan appliqué à une masse mécanique, le mouvement hors-plan est transmis par la masse à une ou plusieurs jauges de contrainte suspendues. Les jauges de contrainte peuvent être par exemple du type jauge piézorésistive.

Toujours dans le cas du hors-plan, la demande de brevet FR2983844 se rapporte à une liaison mécanique formant pivot pour structure MEMS-NEMS, la liaison pivot étant disposée entre deux pièces, une pièce mobile apte à pivoter par rapport à une pièce fixe, et comprenant une poutre de torsion selon l'axe de la liaison pivot et une poutre de flexion également selon l'axe de la liaison pivot. Une telle structure MEMS-NEMS peut être mise en oeuvre dans un gyromètre ou un accéléromètre en utilisant la pièce mobile comme moyen de détection, celle-ci étant mise en mouvement par une force de Coriolis ou une accélération respectivement. Des jauges de contrainte sont intégrées à la structure afin de détecter le mouvement de la pièce mobile. Les jauges de contraintes sont disposées perpendiculairement à l'axe de rotation de la liaison pivot et elles sont en outre disposées pour obtenir une lecture différentielle.

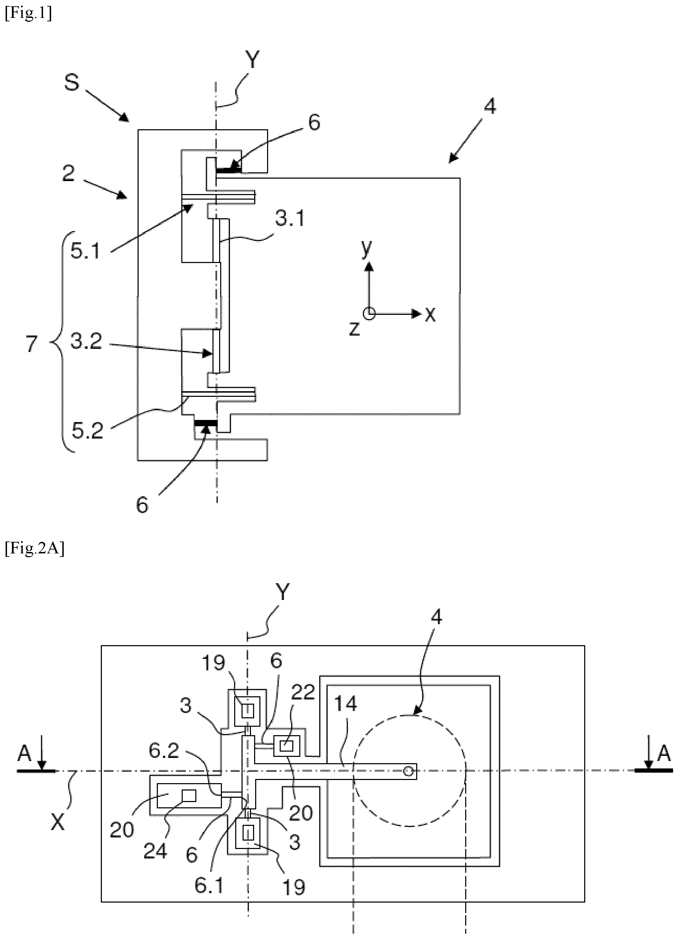

Une telle structure de l'art antérieur est illustrée dans la figure 1 qui montre une structure S pour un accéléromètre comportant une pièce fixe 2, par exemple un substrat, une pièce mobile 4 suspendue par rapport à la pièce fixe 2 et une liaison pivot 7 d'axe Y reliant la pièce fixe 2 et la pièce mobile 4.

La liaison pivot 7 comporte deux premières poutres 3.1, 3.2 alignées avec l'axe de pivot Y, reliées par chacune de leur extrémité à la pièce fixe 2 et à la pièce mobile 4, et travaillant en torsion autour de l'axe Y. La liaison pivot 7 comporte en outre deux deuxièmes poutres 5.1, 5.2 disposées perpendiculairement à l'axe de pivot Y, reliant la pièce fixe 2 à la pièce mobile 4, et travaillant en flexion angulaire autour de l'axe Y.

La structure S comporte également des moyens de détection du déplacement de la pièce mobile 4 par rapport à la pièce fixe 2 qui sont formés par des jauges de contrainte 6. Les deux jauges 6 sont attachées chacune d'un côté et de l'autre de l'axe de pivot Y, afin d'obtenir une lecture différentielle. Une telle liaison pivot et un bras de levier peuvent être utilisés pour un capteur de pression MEMS-NEMS tel que décrit dans la demande de brevet FR2977319.

Les figures 2A 2B illustrent un capteur de pression de l'art antérieur comportant un substrat 2, une membrane 4 suspendue sur le substrat et apte à se déformer sous l'action d'une différence de pression entre ses deux faces, et des jauges de contrainte 6 de la déformation de la membrane fixées sur le substrat.

La membrane 4 est soumise sur une de ses faces 4.1 à la pression P que l'on souhaite mesurer.

L'autre face 4.2 est soumise à une pression de référence qui est réalisée dans une cavité 10 formée entre la membrane 4 et un capot 12 scellé sur le substrat 2. Dans le cas d'un capteur de pression absolue, le vide est réalisé dans la cavité 10.

Le capteur comprend en outre un bras de levier 14 d'axe longitudinal X apte à transmettre la déformation de la membrane 4 aux jauges de contrainte 6. Le bras de levier 14 est couplé en déplacement selon Z à la membrane 4 et est monté mobile en rotation selon l'axe de rotation Y par rapport au substrat 2. Grâce au bras de levier, la contrainte vue par les jauges 6 (au niveau de leurs extrémités 6.1) est amplifiée par rapport à la force récoltée par la membrane 4.

La rotation du bras 14 autour de l'axe de rotation Y est permise par une liaison pivot formée par deux poutres 3 sollicitées en torsion autour dudit axe de rotation Y. Les deux jauges de contrainte 6 sont attachées de part d'autre de l'axe de rotation Y et du bras 14. Les poutres en torsion 3 peuvent être remplacées par des poutres en flexion ou par une combinaison de poutres en flexion et en torsion, dans la mesure où cela permet de réaliser une liaison pivot selon l'axe de rotation Y.

Des plots d'ancrage 20 fixent les jauges 6 (au niveau de leurs extrémités 6.2) sur le substrat 2 et sur les plots d'ancrage des jauges sont formés des contacts électrique 22, 24. Des plots d'ancrage 19 lient les poutres 3 au substrat 2 et permettent la polarisation électrique du MEMS et du point milieu des deux jauges.

Lorsqu'une différence de pression apparait entre la face 4.2 et la face 4.1 de la membrane, la membrane se déforme, soit vers l'intérieur de la cavité, soit vers l'extérieur de la cavité en fonction de la valeur de la pression à mesurer par rapport à la pression de référence. Cette déformation induit une force sur le bras de levier 14 couplé fortement en Z avec la membrane 4, ce qui a pour effet de générer une contrainte sur les jauges de contrainte 6. Cette contrainte est amplifiée du fait du bras de levier 14 et de son pivotement autour de l'axe de rotation Y. La contrainte subie par les jauges 6 est alors mesurée, par exemple en mesurant la variation de résistance électrique des jauges dans le cas de jauges piézorésistives. Ces mesures permettent alors de déterminer la différence de pression vue par la membrane et la pression de l'environnement.

Dans la configuration de jauges présentée pour l'accéléromètre ou le capteur de pression, on constate que leur comportement différentiel n'est pas parfait et qu'une jauge est plus sensible que l'autre. Or un objectif de la lecture différentielle est d'annuler les erreurs communes entre les deux jauges lors de la soustraction des signaux par l'électronique de lecture ; si les deux jauges n'ont pas la même sensibilité, les erreurs ne s'annulent plus.

Globalement, cela peut s'expliquer par le manque de symétrie de la structure au niveau des jauges. D'une part, lorsqu'une jauge fonctionne en étirement, l'autre fonctionne en compression et inversement. Or il n'est pas évident d' avoir un comportement mécanique des j auges symétrique en compression et en tension. Si ce n'est pas le cas, les raideurs de chaque côté du bras de levier ne sont pas les mêmes, ce qui peut fausser son déplacement et aboutir à une contrainte de compression d'une jauge différente de la contrainte d'étirement de l'autre. D'autre part, le bras de levier, considéré comme indéformable, doit transmettre les efforts de manière identique sur chacune des deux j auges. Or cette hypothèse n'est pas respectée si une partie du bras qui contacte une jauge se déforme par rapport à une autre partie qui contacte l'autre j auge. Typiquement, une partie du bras est plus grande pour contourner et connecter une jauge de l'autre côté de l'axe de rotation, contrairement à l'autre j auge qui est branchée en direct. Si cette partie de bras se déforme, la jauge branchée en direct sera plus contrainte. Enfin, un stress initial dans les jauges, par exemple un stress dû au dopage de la structure pour la rendre conductrice, peut avoir tendance à faire tourner le bras de levier dans le plan et une telle déformation initiale pourrait suffire à rompre significativement le comportement symétrique de la structure.

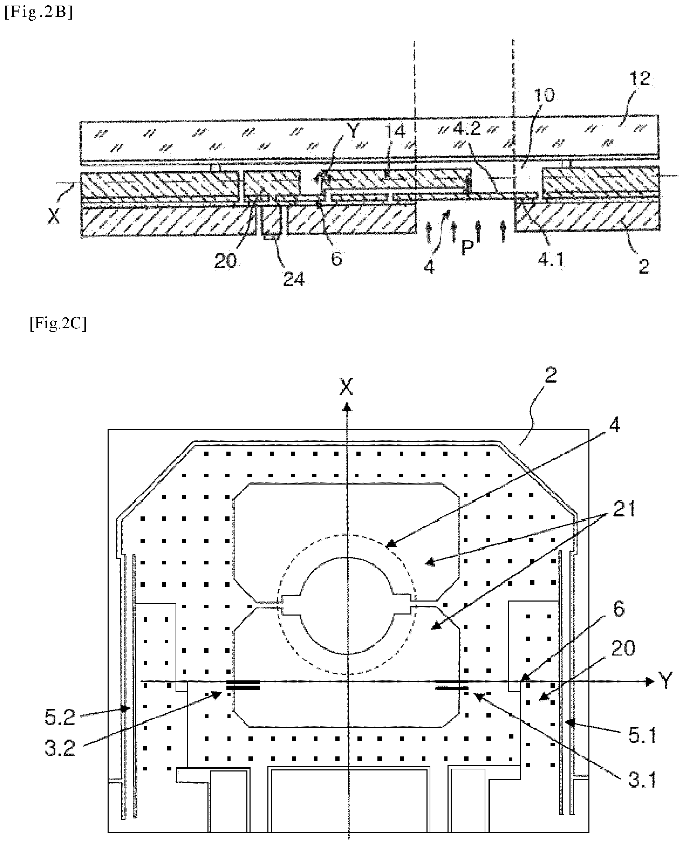

Afin de résoudre ce problème, une solution peut être de disposer les jauges sur l'axe de symétrie de la structure, c'est-à-dire sur l'axe X dans les figures 1, 2A et 2B. Cette solution peut être mise en oeuvre en :
- alignant les jauges sur l'axe de symétrie X ;
- écartant les deux jauges de l'axe de rotation Y pour laisser la place entre elles pour une poutre liée à la pièce mobile (ou masse mobile) ;
- trouant la masse pour y insérer les plots d'ancrage des deux jauges.

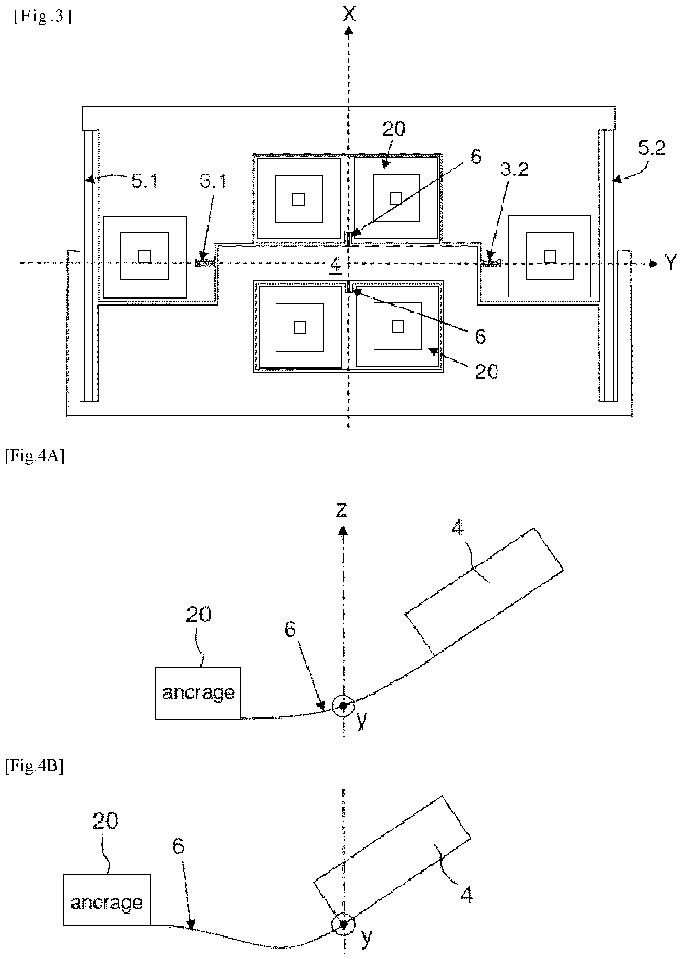

Cette solution est représentée en figure 3 qui représente un accéléromètre comprenant un substrat fixe (non représenté) et une masse mobile 4, ainsi que deux poutres en torsion 3.1 et 3.2 et deux poutres en flexion 5.1 et 5.2 créant une liaison pivot selon un axe de rotation Y. L'accéléromètre comprend en outre deux jauges de contraintes 6 disposées sur l'axe de symétrie X de la structure et de part et d'autre de l'axe de rotation Y de manière à laisser la place à la masse mobile 4. Les jauges 6 sont fixées au substrat par des plots d'ancrage 20.

Cette solution apporte beaucoup d'avantages, mais elle présente cependant des limitations.

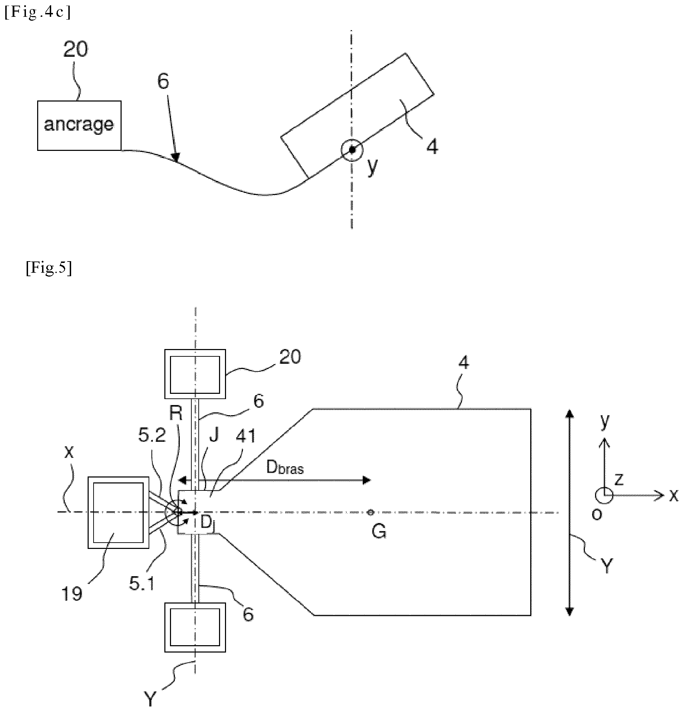

Premièrement, des jauges 6 positionnées sur l'axe de symétrie mais décalées par rapport à l'axe de rotation ne travaillent plus en flexion angulaire pure. Cette problématique peut se comprendre en se référant aux figures 4A, 4B et 4C qui représentent la coupe d'une jauge 6 accrochée d'une part à un plot d'ancrage 20 et d'autre part à la pièce mobile 4 dont elle mesure le mouvement. Comme la pièce mobile (bras de levier, masse ...) est animée d'un mouvement de rotation hors-plan Z autour une direction de rotation Y perpendiculaire à Z, chaque jauge subit une flexion angulaire de par sa liaison avec ladite pièce mobile, et ce, en plus de la compression et/ou de la tension recherchée. Les figures 4A, 4B et 4C montrent que, lorsque la jauge est centrée sur l'axe de rotation (figure 4A), sa déformation, en dehors de la compression recherchée, est une flexion angulaire pure. En revanche, lorsqu'on décentre les jauges (figures 4B et 4C), notamment pour laisser une place à la masse centrale, on complexifie la déformation de la jauge en ajoutant une flexion hors-plan non désirée. Le cas de la figure 3 correspond au positionnement de la figure 4C. Ce mouvement parasite va induire des contraintes supplémentaires qui ne créent aucun signal utile et qui peuvent fragiliser la jauge, notamment en cas de chocs. Pour réduire le mouvement parasite, il faut minimiser l'écart des jauges. Cependant, il est nécessaire de conserver une largeur de masse centrale minimale pour qu'elle soit suffisamment rigide afin de transmettre le mouvement de ladite masse centrale mobile aux jauges. Il y a donc là une contradiction qui est généralement solutionnée par un compromis.

Deuxièmement, cette solution nécessite de disposer les plots d'ancrage des jauges au niveau central de la structure, du moins au plus près de la pièce mobile. Ceci n'est généralement pas possible, notamment pour un capteur de pression. On comprend sur la Figure 2C, qui représente une structure de capteur de pression où la liaison pivot est formée par deux poutres en flexion 5.1, 5.2 et deux poutres en torsion 3.1, 3.2, qu'il ne resterait pas de place pour des plots d'ancrage 20 de jauges 6 si on souhaitait les déplacer au niveau de l'axe de symétrie X où sont déjà disposés les plots 21 de la membrane 4.

Enfin, dans le cas d'une détection par poutre de résonance, le nombre de plots nécessaire est encore plus important. La détection résonante nécessite plus d'éléments actifs et donc plus de plots pour ces éléments actifs : en effet, au lieu de compresser directement une jauge piézorésisitive, on compresse une poutre résonante, que l'on excite (un élément actif et donc au moins un voire deux plots) sur son premier mode de déformation, et que l'on mesure grâce à une ou deux jauges piézorésistives (nécessite en général trois plots). Une détection par poutre de résonance peut nécessiter au moins cinq plots, et ce, au centre de la structure. Pour une mesure différentielle, il faut deux poutres de résonance donc au moins dix plots. Il est donc encore moins aisé de disposer ces jauges et leurs plots au centre de la structure.

Ces inconvénients apparaissent aussi dans les capteurs à détection dans le plan, comme l'accéléromètre de type MEMS et/ou NEMS à déplacement dans le plan décrit dans la demande de brevet FR2951826

Un tel accéléromètre de l'art antérieur est représenté en Figure 5. L'accéléromètre comprend une masse 4 formant bras de levier dont une partie plus fine 41, maintenue à un substrat par deux poutres de flexion 5.1, 5.2 orthogonales entre elles formant une charnière dont l'axe de rotation se trouve à l'intersection des deux poutres. Les poutres sont fixées au substrat par un plot d'ancrage 19. La faible raideur en flexion des poutres autorise la rotation dans le plan du substrat OXY, l'axe de rotation Z étant perpendiculaire audit plan. Par ailleurs, les poutres bloquent les autres déplacements dans le plan par leur forte raideur en compression, et elles bloquent les mouvements hors-plan par leur forte raideur en flexion hors-plan. Deux jauges de contrainte 6 sont placées à proximité du centre de rotation R pour obtenir un grand facteur d'amplification sur le bras de levier. Les jauges sont fixées au substrat par un plot d'ancrage 20. On se retrouve dans le premier problème énoncé ci-dessus en lien avec les figures 4A, 4B, 4C. En effet, pour obtenir une flexion angulaire pure en plus de la compression voulue, les jauges devraient être centrées sur l'axe X. Ainsi, il faudrait limiter leur éloignement, tout en conservant un bras de levier assez rigide, d'où le compromis qui dimensionne la largeur de la masse entre les deux jauges.

En outre, le problème de la place manquante pour les plots d'ancrage peut également apparaitre, notamment si la détection est réalisée à l'aide d'une poutre résonante (et a fortiori à l'aide de plusieurs poutres résonantes).

L'invention vise à surmonter les inconvénients précités de l'art antérieur.

Plus particulièrement elle vise à disposer d'une structure MEMS et/ou NEMS, notamment pour réaliser un capteur, qui permette d'éviter des contraintes parasites sur une jauge de contrainte, une poutre résonante (ou tout détecteur de mouvement susceptible de subir une telle contrainte) notamment pour améliorer la mesure différentielle, sans nécessairement avoir besoin d'agrandir la structure.

### Expose de l'invention

Une solution permettant de remédier à ces inconvénients concerne une liaison mécanique ainsi qu'une structure et un capteur comprenant une telle liaison mécanique.

Un premier objet de l'invention concerne une liaison mécanique pour une structure microélectromécanique et/ou nanoélectromécanique, ladite structure comprenant une pièce mobile, une pièce fixe s'étendant selon un plan principal et des moyens de détection du déplacement de la pièce mobile par rapport à la pièce fixe, ladite liaison mécanique comprenant :
- une première liaison reliée à la pièce fixe et à la pièce mobile et apte à autoriser la rotation de ladite pièce mobile par rapport à ladite pièce fixe autour d'un axe de rotation ;
- une deuxième liaison connectant la pièce mobile aux moyens de détection à une distance donnée par rapport à l'axe de rotation selon une direction perpendiculaire audit axe de rotation ;
- une troisième liaison reliée à la pièce fixe et aux moyens de détection et configurée pour guider lesdits moyens de détection en translation selon une direction de translation dans le plan principal de la pièce fixe ;
de sorte que la combinaison de la deuxième liaison et de la troisième liaison soit apte à transformer le mouvement de rotation de la pièce mobile en un mouvement de translation des moyens de détection selon la direction de translation.

Selon l'invention, le « plan principal » désigne le plan de référence de la structure microélectromécanique et/ou nanoélectromécanique, et est généralement désigné « OXY » dans la description. Par souci de simplification, le terme « plan » désigne le plan principal. Des plans autres que le plan principal seront désignés différemment. Le terme « hors plan » est en référence audit plan principal.

Les termes « épaisseur », « épais », « minceur », « mince » sont donnés pour des dimensions perpendiculaires au plan du substrat.

Les termes « fin », « finesse », « large », « largeur », « allongé », « allongement », « longueur », « long » sont donnés pour des dimensions dans le plan du substrat (ou dans un plan parallèle au plan du substrat). Dans la présente description, la longueur désigne la dimension selon la direction X et la largeur désigne la dimension selon la direction Y.

Les termes « mobile » et « fixe » se réfèrent au mouvement relatif d'une pièce par rapport à l'autre.

Le mouvement peut être un déplacement ou une déformation. Ainsi, selon l'invention, le terme « mobile » définit une pièce pouvant se déplacer ou se déformer.

Selon un mode de réalisation, la liaison mécanique comprend en outre une pièce de transmission reliée aux moyens de détection, la deuxième liaison étant reliée à la pièce mobile et à la pièce de transmission. Dans ce cas, la combinaison de la deuxième liaison et de la troisième liaison est apte à transformer le mouvement de rotation de la pièce mobile en un mouvement de translation de la pièce de transmission selon la direction de translation, laquelle pièce de transmission transmettant le mouvement de translation aux moyens de détection.

Selon une première variante de réalisation, la première liaison est une liaison pivot hors-plan par rapport au plan principal de la pièce fixe, c'est-à-dire permettant une rotation hors-plan. En particulier, elle comprend au moins une première lame destinée à travailler en torsion autour d'un axe de rotation et/ou au moins une deuxième lame destinée à travailler en flexion autour de l'axe de rotation, chacune des première et seconde lames étant reliées d'une part à la pièce mobile, et d'autre part à la pièce fixe par exemple à l'aide d'au moins un plot d'ancrage.

Selon un mode de réalisation de la première variante, la première lame est une lame épaisse.

Selon un mode de réalisation de la première variante, la seconde lame est une lame mince. Alternativement, la seconde lame est une lame épaisse.

Selon un mode de réalisation de la première variante, la deuxième liaison comprend une lame épaisse de flexion hors-plan s'étendant selon la direction de translation. Alternativement, la deuxième liaison comprend au moins une lame mince de flexion hors-plan s'étendant selon la direction de translation.

Selon une seconde variante de réalisation, la première liaison est une liaison pivot dans le plan principal de la pièce fixe, c'est-à-dire permettant une rotation dans le plan. En particulier, elle peut comprendre au moins deux lames épaisses de flexion dans le plan non colinéaires et configurées de manière à ce que l'intersection des desdites lames épaisses forme une liaison pivot dans le plan selon un axe de rotation perpendiculaire au plan du substrat.

Selon un mode de réalisation particulier de la seconde variante, la deuxième liaison comprend une lame épaisse de flexion dans le plan s'étendant selon la direction de translation.

Selon un mode de réalisation dans laquelle la liaison mécanique comprend une pièce de transmission reliée aux moyens de détection, la pièce de transmission est formée par un cadre épais, par exemple un cadre à base rectangulaire ou carrée formé par quatre poutres épaisses reliées entre elles le long de leur épaisseur.

Selon un mode de réalisation particulier, la pièce de transmission comprend en outre une poutre centrale s'étendant selon la direction de rotation et disposée sensiblement au milieu du cadre épais.

Selon un mode de réalisation, la troisième liaison comprend au moins une lame épaisse de flexion dans le plan, fine selon la direction de translation et reliée d'une part aux moyens de détection ou à la pièce de transmission et d'autre part à la pièce fixe, par exemple par au moins un plot d'ancrage.

Selon un mode de réalisation alternatif, la troisième liaison comprend au moins une double lame épaisse de flexion dans le plan, ladite double lame épaisse comprenant une première lame épaisse reliée aux moyens de détection ou à la pièce de transmission, une seconde lame épaisse reliée à la pièce fixe, par exemple par au moins un plot d'ancrage et une pièce de liaison intermédiaire reliant les première et seconde lames épaisses.

Un deuxième objet de l'invention concerne une structure microélectromécanique et/ou nanoélectromécanique comprenant une pièce mobile, une pièce fixe s'étendant selon un plan principal, des moyens de détection du déplacement de la pièce mobile par rapport à la pièce fixe et une liaison mécanique selon le premier objet de l'invention, ladite liaison mécanique étant configurée pour relier la pièce mobile et les moyens de détection, lesdits moyens de détection étant disposés de façon à mesurer le déplacement en translation selon la direction de translation.

Selon un mode de réalisation, les moyens de détection comprennent au moins une jauge de contrainte de type piézorésistive ou piézoélectrique, une poutre de résonance, une capacité ou une combinaison desdits moyens.

Selon un mode de réalisation particulier, les moyens de détection comprennent deux jauges de contrainte.

Selon un mode de réalisation, la liaison mécanique de la structure comprend une pièce de transmission reliée aux moyens de détection, la deuxième liaison de la liaison mécanique étant reliée à la pièce mobile de la structure et à ladite pièce de transmission.

La pièce de transmission peut être formée par un cadre épais, par exemple un cadre à base rectangulaire ou carrée formé par quatre poutres épaisses reliées entre elles le long de leur épaisseur Selon un mode de réalisation particulier, les moyens de détection sont disposés à l'intérieur de la pièce de transmission.

Dans le cas où la pièce de transmission est formée par un cadre épais et comprend en outre une poutre centrale s'étendant selon la direction de rotation et disposée sensiblement au milieu du cadre épais, les moyens de détection, par exemple deux jauges, peuvent être disposées de part et d'autre de la poutre centrale.

Un troisième objet de l'invention concerne un dispositif de mesure d'une variation de pression comprenant une structure microélectromécanique et/ou nanoélectromécanique selon le deuxième objet de l'invention et une membrane ou un piston relié(e) à un bras de levier formant la pièce mobile.

Un quatrième objet de l'invention concerne un accéléromètre comprenant une structure microélectromécanique et/ou nanoélectromécanique selon le deuxième objet de l'invention et une masse formant la pièce mobile ou un bras de levier formant la pièce mobile.

### Brève description des figures

D'autres caractéristiques et avantages de l'invention apparaîtront à l'aide de la description qui suit, donnée à titre illustratif et non limitatif, faite en regard des figures annexées parmi lesquelles
[Fig.1] représente un accéléromètre à détection hors-plan de l'art antérieur.
[Fig.2A],
[Fig.2B] et
[Fig.2C] représentent deux capteurs de pression de l'art antérieur.
[Fig.3] représente un capteur dans lequel les jauges de contrainte sont disposées sur l'axe de symétrie.
[Fig.4A] illustre une jauge de contrainte en configuration de flexion pure.
[Fig.4B] et
[Fig.4C] illustrent une jauge de contrainte dans deux configurations de flexion non pure.
[Fig.5] représente un accéléromètre à détection dans le plan de l'art antérieur.
[Fig.6] schématise une liaison mécanique selon l'invention.
[Fig.7A],
[Fig.7B],

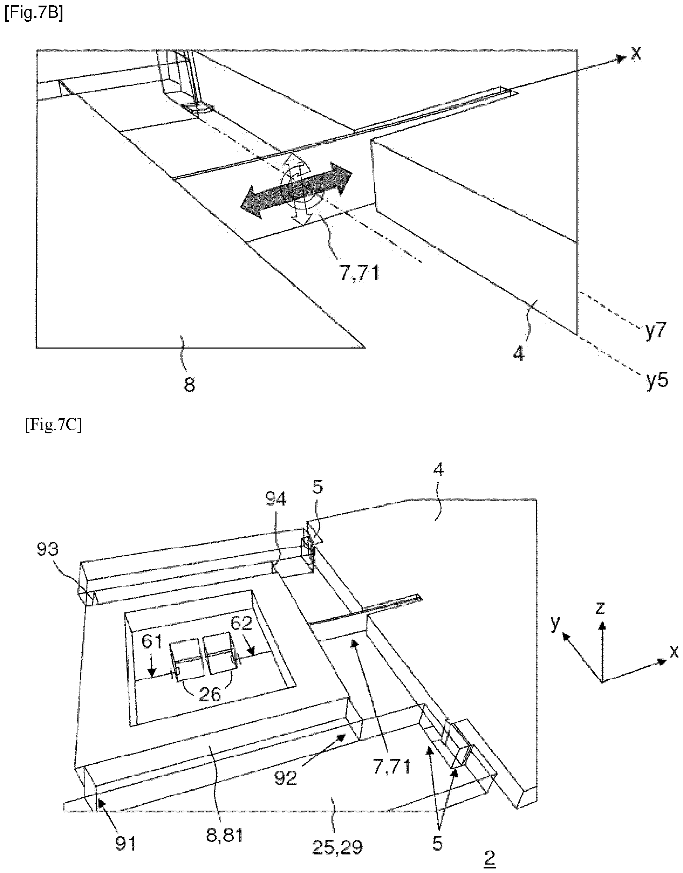

[Fig.7C] et

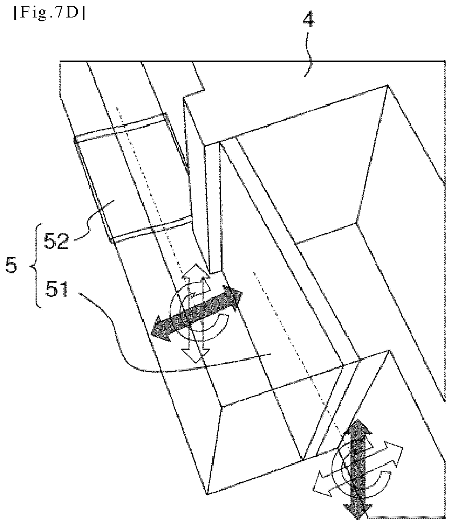

[Fig.7D] représentent différentes vues d'un capteur (accéléromètre à détection hors-plan) selon un premier mode de réalisation.

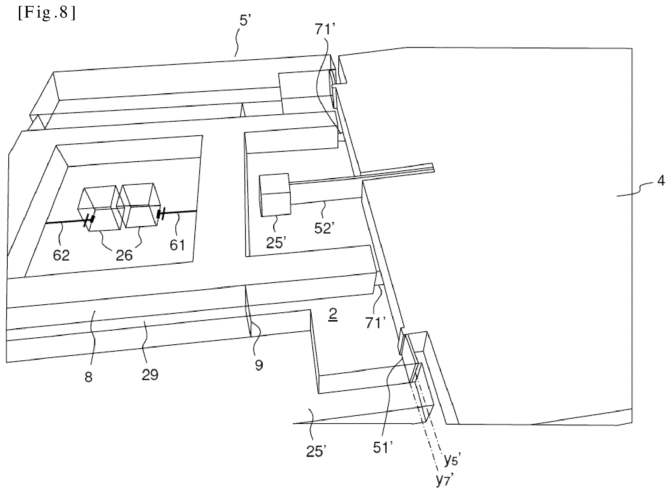

[Fig.8] représente une variante d'une liaison mécanique pour accéléromètre à détection hors-plan selon le premier mode de réalisation.

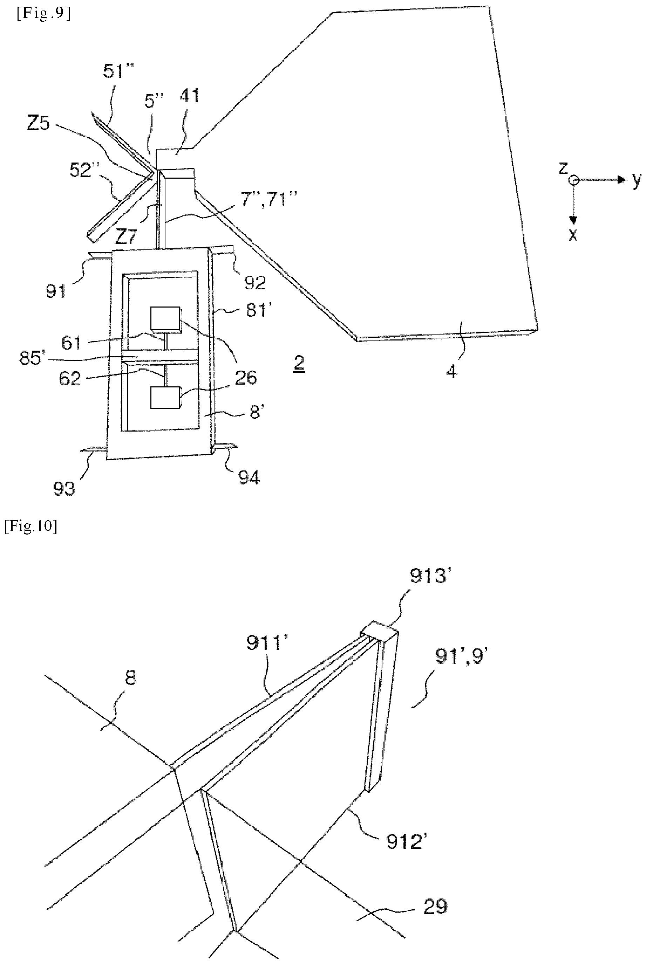

[Fig.9] représente un capteur (accéléromètre à détection dans le plan) selon un second mode de réalisation.
[Fig. 10] représente une variante d'une liaison glissière pour accéléromètre selon le premier ou le second mode de réalisation.

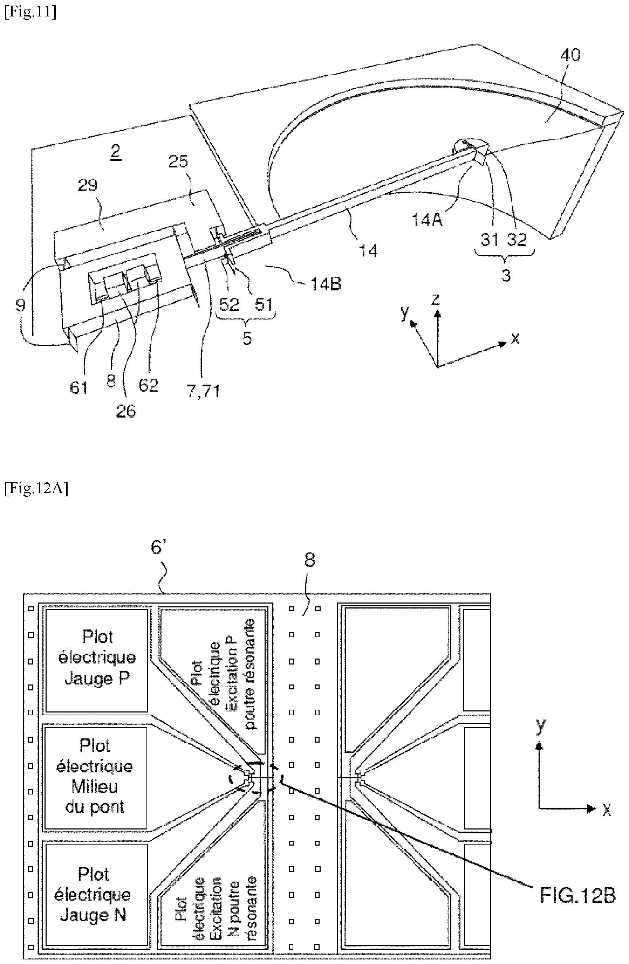

[Fig.11] représente un capteur (dispositif de mesure d'une variation de pression) selon un troisième mode de réalisation de l'invention.
[Fig. 12A] et

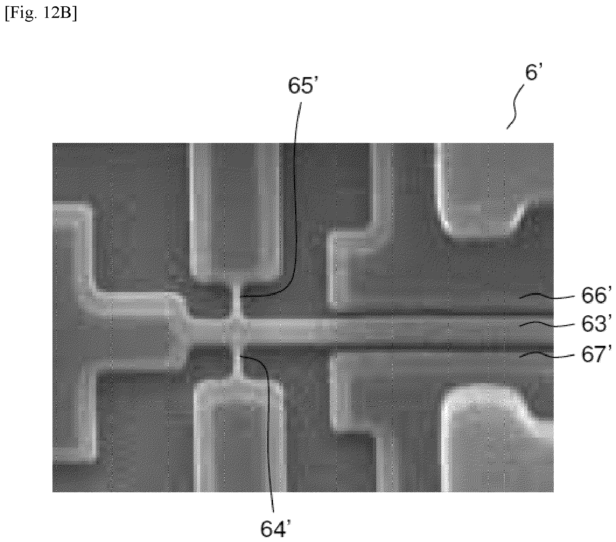

[Fig. 12B] illustrent une variante d'un capteur selon l'invention, les moyens de détection étant de type résonateur.

### Description détaillée de l'invention

Dans l'ensemble de la présente description détaillée, le plan principal (ou « plan ») est désigné par la référence OXY et correspond généralement au plan de la pièce fixe qui est le substrat sur lequel la structure MEMS-NEMS est fabriquée. La direction hors-plan est représentée par la direction Z. La direction de translation dans le plan est représentée par la direction X.

Dans l'ensemble de la présente description détaillée, les éléments remplissant les mêmes fonctions et réalisés de manière similaire structurellement sont désignés par une même référence. Les éléments remplissant les mêmes fonctions mais réalisés de manière différentes structurellement sont désignés par des références différentes.

Les figures 1, 2A, 2B, 2C, 3, 4A, 4B, 4C et 5 ont été décrites précédemment et ne seront pas reprises ici.

L'invention consiste à transformer un mouvement de rotation (hors-plan ou dans le plan de la pièce fixe, par exemple du substrat) d'une pièce mobile (bras de levier, masse...) en un mouvement de translation dans le plan de la pièce fixe. Ladite pièce mobile peut elle-même être rendue mobile par une autre pièce en déplacement (tel un piston) et/ou en déformation (telle une membrane). Ce mouvement de translation obtenu est détecté par une jauge de contrainte, un résonateur, une capacité de condensateur ... (plus largement un détecteur de mouvement). Cela permet notamment de supprimer des contraintes parasites sur le détecteur et peut permettre de déporter ledit détecteur si cela est nécessaire. Cela permet en outre d'améliorer la mesure différentielle et notamment la symétrie de la mesure différentielle.

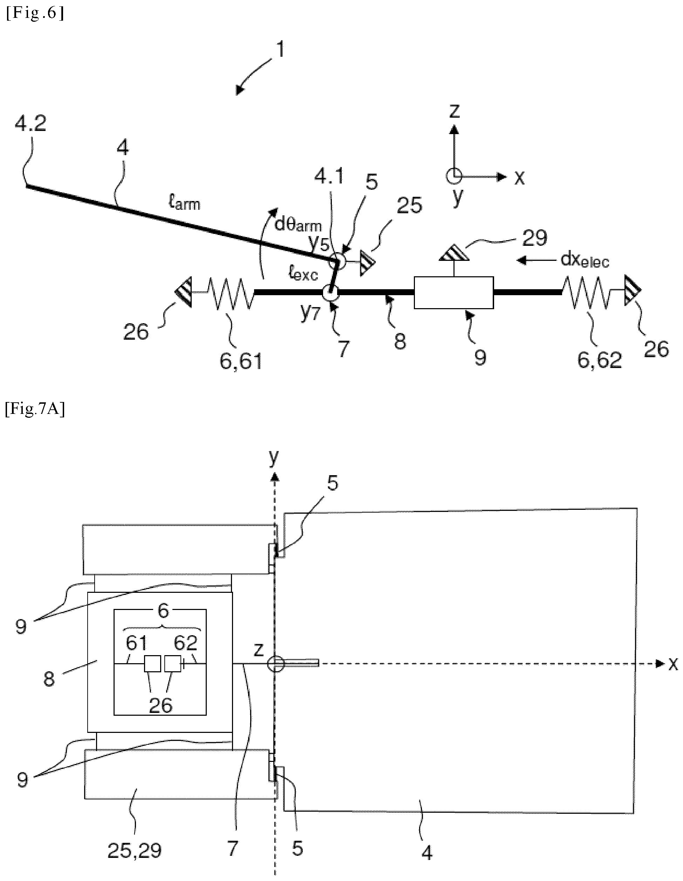

La figure 6 schématise une liaison mécanique selon l'invention dans le cas où la pièce mobile est animée d'un mouvement de rotation hors-plan autour d'une direction de rotation Y et où la liaison mécanique le transforme en un mouvement de translation dans le plan OXY selon une direction de translation X. La figure 6 schématise une liaison mécanique également dans le cas où la liaison mécanique comprend une pièce de transmission.

La liaison mécanique 1 schématisée relie la pièce mobile 4 aux moyens de détection 6. La figure 6 illustre le cas où les moyens de détection 6 comprennent deux jauges de contrainte 61, 62, l'une fonctionne en compression lorsque l'autre fonctionne en tension, et inversement. Chaque jauge de contrainte 61, 62 est fixée à un substrat (non représenté) par un moyen d'ancrage 26. La pièce mobile 4 est par exemple un bras de transmission ou bras de levier. Le substrat s'étend dans le plan OXY.

La liaison mécanique 1 comprend une première liaison 5 (ou liaison pivot) qui est reliée à la pièce mobile 4 au niveau de sa première extrémité 4.1. La première liaison pivot 5 est fixée au substrat par un moyen d'ancrage 25. La première liaison pivot 5 autorise une rotation de la pièce mobile 4 autour d'un axe de rotation Y5, c'est-à-dire une rotation hors-plan par rapport au substrat. La pièce mobile 4 tourne sous l'effet d'une force selon la direction Z appliquée au niveau de sa seconde extrémité, ou extrémité libre, 4.2. Cette force peut être d'origine inertielle dans le cas d'un accéléromètre, ou issue de la différence de pression sur les surfaces d'une membrane pour un capteur de pression, ou encore sous l'effet d'un champ magnétique pour un magnétomètre ...

La liaison mécanique comprend en outre une deuxième liaison 7 associée à la première liaison 5 et reliée à la pièce mobile 4. La deuxième liaison 7 autorise une flexion selon un axe de flexion Y7 qui suit la même direction Y que l'axe de rotation Y5, mais qui est excentré d'une distance l_{exc} dans la direction hors-plan Z. Par ailleurs, elle assure un couplage fort dans la direction de translation X entre la pièce mobile 4 et une pièce de transmission 8 décrite ci-dessous.

La liaison mécanique représentée comprend en outre une pièce de transmission 8 reliée à la seconde liaison 7, et une troisième liaison 9 de type liaison glissière apte à guider la pièce de transmission 8 mobile en translation dans le plan OXY (selon la direction de translation X). La liaison glissière 9 est fixée au substrat par un moyen d'ancrage 29. L'excentricité selon la direction Z de la seconde liaison 7 combinée avec la liaison de type glissière 9 fait que le mouvement hors-plan de la pièce mobile 4 est transformé en une translation selon la direction de translation X de la pièce de transmission 8, donc dans le plan OXY du substrat. La seconde liaison 7, pour éviter de rendre le système hyperstatique au niveau de la pièce 8 lors de sa combinaison avec la liaison glissière 9, doit pouvoir transmettre une translation à la pièce de transmission 8 selon la direction de translation X tout en autorisant une rotation de la pièce mobile 4 autour de la direction de rotation Y. Elle doit donc autoriser un léger déplacement selon la direction Z. Cette seconde liaison peut être nommée « liaison de couplage ».

La pièce de transmission 8 mobile est reliée à chacune des deux jauges de contrainte 61, 62 de manière à leur transmettre une force de compression et/ou de tension. Comme la pièce de transmission 8 est mobile en translation dans le plan, les jauges ne subissent qu'une compression pure ou une tension pure, sans déformation parasite. Ainsi, la position des jauges est sans conséquence. Il n'y a notamment plus de contrainte de place pour le positionnement des plots d'ancrage des jauges.

La deuxième liaison peut être reliée directement aux moyens de détection, c'est-à-dire sans pièce de transmission, et transmettre ainsi la translation directement aux moyens de détection, plus précisément à au moins une pièce mobile desdits moyens de détection. Et dans ce cas, la troisième liaison de type liaison glissière est configurée pour guider ladite pièce mobile des moyens de détection selon la direction de translation dans le plan.

Dans le cas d'une liaison mécanique permettant de transformer un mouvement de rotation dans le plan en un mouvement de translation dans le plan, l'axe de rotation est dans une direction perpendiculaire au plan. Par exemple, l'axe de rotation est alors selon la direction Z. En d'autres termes, la pièce mobile tourne autour de la direction Z perpendiculaire au plan OXY, la pièce mobile et la liaison mécanique sont alors vues dans le plan OXY.

Les figures 7A à 7D représentent différentes vues d'un capteur (accéléromètre à détection hors-plan) selon un premier mode de réalisation. Les flèches grises indiquent les directions de couplage des liaisons et les flèches blanches indiquent les directions souples des liaisons.

La première liaison 5 est formée par deux lames épaisses de torsion 51 et deux lames minces de flexion 52 hors-plan (détail en figure 7D). Chaque lame est reliée d'une part à une masse mobile 4, formant la pièce mobile, et d'autre part à un substrat 2, formant la pièce fixe, par un plot d'ancrage 25. Le substrat 2 s'étend dans le plan OXY (plan principal). Les lames de torsion 51, gravées dans la couche épaisse, bloquent la translation hors-plan grâce à leur forte raideur de flexion en Z et leur ancrage, tout en présentant une faible raideur angulaire grâce à leur faible longueur selon la direction X, autorisant une torsion autour de la direction Y. Les lames de flexion 52 hors-plan, gravées dans la couche mince, bloquent toute translation dans le plan grâce à leur forte raideur de compression dans la direction X, leur forte raideur de compression selon Y et leur ancrage, tout en présentant une faible raideur angulaire grâce à leur faible épaisseur, autorisant une flexion hors-plan autour de la direction Y. La combinaison des deux lames épaisses de torsion 51 et deux lames minces de flexion 52 bloque ainsi les translations hors-plan et dans le plan, tout en autorisant une rotation hors-plan, plus précisément autour de la direction Y. L'axe de rotation Y5 est ainsi défini à la base de la couche épaisse (MEMS) des lames de torsion 51, à l'intersection du coeur de la couche mince (NEMS) des lames de flexion 52 et du coeur de la couche épaisse (MEMS) des lames de torsion 51. La première liaison pivot 5 autorise une rotation de la masse 4 autour de l'axe de rotation Y5, donc une rotation hors-plan par rapport au substrat 2.

La pièce mobile peut être alternativement formée par un bras de levier (non représenté sur les figures 7A à 7D) qui peut être une partie plus fine de la masse mobile ou une pièce différente de la masse mobile mais reliée à ladite masse de manière à transmettre et amplifier le mouvement de ladite masse mobile.

La liaison de couplage 7 adaptée pour transformer le mouvement de rotation de la masse 4 en un mouvement de translation à la pièce de transmission 8 consiste en une lame épaisse 71 de flexion hors-plan reliée d'une part à la masse 4 et d'autre part à la pièce de transmission 8. La forte raideur en compression selon la direction X de cette lame épaisse (détail en figure 7B), permet de coupler fortement le mouvement dans le plan de la masse 4 au milieu de ladite lame et de la pièce de transmission 8. Même si la lame épaisse de flexion 71 présente une forte épaisseur, elle autorise une rotation en flexion autour de la direction Y et ainsi un faible mouvement hors-plan qui permettent de faire cohabiter la rotation de la masse 4 et la translation de la pièce de transmission 8.

Avantageusement, la lame de couplage 7 est centrée au-dessus (selon la direction Z) de l'axe de rotation Y5 de la masse 4 pour se rapprocher le plus possible d'une flexion angulaire pure et minimiser la raideur de la liaison. Comme on l'a vu pour les flexions des jauges sur les figures 4A à 4C, centrer une poutre à faire fléchir autour de l'axe de rotation permet de limiter sa déformation à une flexion angulaire pure. C'est donc dans cette configuration que la lame de couplage opposera le moins de raideur.

Cette lame peut être modélisée par une matrice de raideur diagonale en son centre, donc au milieu de la couche MEMS. Comme l'axe de flexion Y7 de la liaison de couplage 7 apparait au milieu de l'épaisseur MEMS, ici au-dessus de l'axe de rotation Y5, on obtient bien l'excentricité nécessaire entre les première et seconde liaisons. La lame épaisse de flexion hors-plan formant la liaison de couplage 7 peut donc être vue comme une biellette connectée entre la masse 4 et la pièce de transmission 8.

La pièce de transmission 8 illustrée est formée par un cadre rectangulaire 81, qui peut en particulier être carré, formé par quatre lames épaisses reliées entre elles le long de leurs épaisseurs.

La pièce de transmission 8 mobile est reliée à deux jauges de contrainte 61, 62 dans une configuration telle qu'elle peut transmettre à l'une une force de compression alors qu'elle transmet à l'autre une force de tension, et inversement.

Dans l'exemple illustré, en référence notamment aux figures 7A et 7C, les jauges de contrainte 61, 62 sont disposées à l'intérieur du cadre rectangulaire 81 formant la pièce de transmission et sont disposées sur la direction de translation X (qui est aussi l'axe de symétrie de la structure) dans ledit cadre de manière symétrique par rapport à la direction Y. Ainsi les jauges de contrainte sont connectées avec les deux côtés du cadre rectangulaire opposés selon la direction X. Par ailleurs, les jauges de contrainte sont reliées au substrat 2 par des plots d'ancrage 26 disposés à l'intérieur du cadre rectangulaire.

La pièce de transmission 8 est maintenue en translation dans le plan par au moins deux lames épaisses 91, 92 de flexion dans le plan ancrées au substrat par au moins un plot d'ancrage 29, les lames formant la troisième liaison ou liaison glissière 9. Ces lames présentent une forte raideur hors-plan, due à leur forte épaisseur et leur ancrage. De plus, leur forte raideur en compression due à leur forte largueur selon la direction Y permet de bloquer la translation selon cette direction Y. Enfin, leur faible longueur selon la direction X génère une faible raideur dans cette direction X. Cela permet de guider la translation de la pièce de transmission 8 selon la direction X.

La liaison de couplage 7 combinée avec la liaison glissière 9 permet de transformer la rotation de la masse 4 autour de la direction Y en une translation de la pièce de transmission 8 selon la direction X.

Comme la pièce de transmission 8 est mobile en translation dans le plan (selon la direction X), les jauges de contrainte ne subissent qu'une compression pure ou une tension pure, sans déformation parasite. Ainsi, la position des jauges est sans conséquence. Il n'y a notamment plus de contrainte de place pour le positionnement des plots d'ancrage des jauges puisque celles-ci peuvent être déportées.

Selon un mode avantageux, au moins trois lames épaisses 91, 92, 93 de flexion forment la liaison glissière 9, ce qui permet de bloquer toute rotation dans le plan OXY. Alternativement, deux lames épaisses suffisamment éloignées entre elles selon la direction X suffisent à bloquer la rotation dans le plan OXY. Dans le mode illustré, il y a quatre lames épaisses 91, 92, 93, 94 de flexion, ce qui permet d'améliorer la symétrie.

Selon une variante du premier mode de réalisation illustrée en figure 8, pouvant s'appliquer à une autre structure selon l'invention, la première liaison pivot 5' peut être formée par deux lames épaisses 51' de torsion de type de celles illustrées en figure 7D (référence 51) et au moins une lame épaisse 52' de flexion hors-plan du type de celle illustrée en figure 7B (référence 71). Dans ce cas, la lame épaisse 52' de flexion hors-plan est reliée au substrat 2 par un plot d'ancrage 25' et non à la pièce de transmission 8. La lame épaisse 52' de flexion hors-plan est reliée d'autre part à la masse 4. L'axe de rotation Y5' est alors au milieu de la couche épaisse MEMS (et non plus au pied de la couche épaisse i.e. non plus au coeur de la couche mince NEMS). Par ailleurs, la seconde liaison ou liaison de couplage 7' est alors formée par des lames minces 71' en flexion hors-plan de type de celles illustrées en figure 7D (référence 52). Celles-ci, au lieu d'être liées à des plots d'ancrage sont reliées à la pièce de transmission 8. L'axe de flexion Y7' de la liaison de couplage 7 est alors au coeur de la couche fine NEMS, c'est-à-dire au pied de la couche épaisse MEMS et elle est en dessous de l'axe de rotation Y5'.

La figure 9 représente un capteur (accéléromètre à détection dans le plan) selon un second mode de réalisation.

Comme pour l'accéléromètre de l'état de la technique illustré en figure 5, l'accéléromètre comprend une masse 4 formant un bras de levier et comprenant une extrémité 41. Au niveau de ladite extrémité, la masse est maintenue à un substrat 2 par deux lames épaisses de flexion 51", 52" orthogonales entre elles, l'intersection des deux lames épaisses formant l'axe de rotation Z5 de la première liaison pivot 5", qui est selon la direction Z perpendiculaire au plan du substrat OXY. Ainsi, la masse 4 décrit un mouvement de rotation dans ledit plan autour dudit axe de rotation Z5. Comme pour l'accéléromètre hors-plan, la seconde liaison ou liaison de couplage 7" est formée par une lame épaisse 71" en flexion allongée selon la direction X et fine selon la direction Y. Mais contrairement à l'accéléromètre hors-plan, elle permet une flexion dans le plan, autour d'un axe de flexion Z7 qui suit la même direction que l'axe de rotation Z5, mais qui est excentré dans la direction X. La lame épaisse 71" en flexion est reliée à une pièce de transmission 8'.

La pièce de transmission 8' est maintenue en translation dans le plan par au moins deux lames épaisses 91, 92 de flexion dans le plan, fixées au substrat par au moins un plot d'ancrage 29, les lames formant la troisième liaison ou liaison glissière 9 de la même manière que pour l'accéléromètre hors-plan. Ces lames présentent une forte raideur hors-plan, due à leur forte épaisseur. De plus, leur forte raideur en compression selon la direction Y permet de bloquer la translation selon cette direction Y. Enfin, leur faible longueur selon la direction X génère une faible raideur dans cette direction X. Cela permet de guider la translation de la pièce de transmission 8' selon la direction X.

Selon un mode avantageux, au moins trois lames épaisses 91, 92, 93 de flexion forment la liaison glissière 9, ce qui permet de bloquer toute rotation dans le plan OXY. Alternativement, deux lames épaisses suffisamment éloignées entre elles selon la direction X suffisent à bloquer la rotation dans le plan OXY. Dans le mode illustré, il y a quatre lames épaisses 91, 92, 93, 94 de flexion, ce qui permet d'améliorer la symétrie.

La liaison de couplage 7" combinée avec la liaison glissière 9 permet de transformer la rotation de la masse 4 dans le plan autour de la direction Z en une translation de la pièce de transmission 8' selon la direction X.

La pièce de transmission 8' comprend une poutre centrale 85' s'étendant selon la direction Y et reliée à deux jauges de contraintes 61, 62 disposées de part et d'autre de ladite poutre centrale de manière à transmettre à l'une une force de compression alors que l'autre reçoit une force de tension, et inversement. Les jauges de contraintes sont reliées au substrat 2 par des plots d'ancrage 26. Comme la pièce de transmission 8' est mobile en translation dans le plan, les jauges de contrainte ne voient plus une rotation mais une compression pure ou une tension pure, donc sans déformation parasite. Ainsi, la position des jauges est sans conséquence. Il n'y a notamment plus de contrainte de place pour le positionnement des plots d'ancrage des jauges.

Cette variante de la pièce de transmission avec une poutre centrale et des jauges de contrainte disposées de part et d'autre de ladite poutre centrale peut être appliquée à d'autres structures MEMS-NEMS notamment la structure pour accéléromètre hors-plan des figures 7A à 7D.

De même, la variante de la pièce de transmission sans poutre centrale telle qu'illustrée en figures 7A et 7C peut s'appliquer à d'autres structures MEMS-NEMS que l'accéléromètre hors-plan et notamment à l'accéléromètre plan de la figure 9.

Selon une variante de réalisation du premier ou du second mode de réalisation, qui peut s'appliquer à une autre structure selon l'invention, la troisième liaison 9' peut être formée par des doubles lames 91' de flexion dans le plan, plutôt que par les simples lames épaisses 91 de flexion dans le plan illustrés en figure 7C ou en figure 9.

Cette variante de troisième liaison est illustrée en figure 10. La double lame 91' représentée comprend deux lames 911', 912' se rejoignant en formant un U, chaque lame étant allongée selon l'axe Y et fine selon l'axe X. La première lame 911' est reliée à la pièce de transmission 8, la seconde lame 912' est reliée au substrat par un plot d'ancrage 29. Les deux lames 911' et 912' sont par ailleurs reliées entre elles par une pièce de liaison intermédiaire 913'. Cette configuration oppose une raideur beaucoup plus linéaire à la pièce de transmission 8 lors de son déplacement dans la direction souhaitée X, notamment lors de forts déplacements, même si cela fournit moins de raideur selon la direction Y.

La figure 11 représente un capteur (dispositif de mesure d'une variation de pression) selon un troisième mode de réalisation. Il peut s'agir d'un microphone ou d'un capteur de pression absolu ou différentiel. Pour plus de lisibilité, certaines parties, comme par exemple les plots d'ancrage, ne sont représentées que dans un demi-plan.

Le dispositif comprend une membrane 40 réalisée dans la couche mince (NEMS) avec par exemple une épaisseur de l'ordre de 1 µm afin que la membrane assure une étanchéité tout en restant souple. Dans le cas d'un microphone, l'étanchéité n'est pas obligatoire.

Le déplacement hors plan du centre de la membrane 40 est transféré à une première extrémité 14A d'un bras de levier 14, par exemple à l'aide d'une liaison de couplage hors-plan 3 formée par au moins une lame épaisse 31 de torsion et par un élément de fixation 32 de la lame épaisse 31 sur la membrane. De par la forte épaisseur de cette lame, cette liaison de couplage hors-plan permet de coupler fortement la translation hors-plan (selon la direction Z). En outre, la finesse de la lame 31 dans la direction X autorise une déformation angulaire en torsion autour d'un axe de torsion parallèle à la direction Y et une flexion selon la direction X. Ainsi le bras de levier 14, animé d'un mouvement de rotation, et la membrane 40 en mouvement hors plan, peuvent être couplés dans la direction Z sans aboutir à un système hyperstatique.

Le bras de levier 14 est de préférence gravé dans la couche épaisse (MEMS) pour obtenir une rigidité suffisante.

La seconde extrémité 14B du bras de levier est reliée à la première liaison 5 (également nommée liaison pivot) à la base de la couche épaisse. Comme dans la configuration de l'accéléromètre hors-plan des figures 7A à 7D, la première liaison 5 est formée par deux lames épaisses de torsion 51 et deux lames minces de flexion 52 hors-plan. Chaque lame est reliée d'une part au bras de levier 14 et d'autre part au substrat 2 de la structure MEMS-NEMS, à l'aide d'un plot d'ancrage 25. Le substrat 2 s'étend dans le plan OXY (plan principal). Les lames de torsion 51, gravées dans la couche épaisse, bloquent la translation hors-plan grâce à leur forte raideur de flexion en Z et leur ancrage, tout en présentant une faible raideur angulaire grâce à leur faible longueur selon la direction X, autorisant une torsion autour de la direction Y. Les lames de flexion 52 hors-plan, gravées dans la couche mince, bloquent la translation dans la direction X grâce à leur forte raideur de compression dans cette direction X et leur ancrage, tout en présentant une faible raideur angulaire grâce à leur faible épaisseur, autorisant une flexion autour de la direction Y. La combinaison des deux lames épaisses de torsion 51 et deux lames minces de flexion 52 bloque ainsi les translations hors-plan et dans le plan, tout en autorisant une rotation hors-plan autour d'un axe de rotation Y5 selon la direction Y et qui est ainsi défini à la base de la couche épaisse (MEMS) des lames de torsion 51, à l'intersection du coeur de la couche mince (NEMS) des lames de flexion 52 et du coeur des lames de torsions 51. La première liaison pivot 5 autorise ainsi une rotation du bras de levier 14 autour de l'axe de rotation Y5, donc une rotation hors-plan par rapport au substrat 2.

De même, comme dans la configuration de l'accéléromètre hors-plan des figures 7A à 7D, la deuxième liaison 7 (également nommée liaison de couplage) adaptée pour transmettre le mouvement de rotation du bras de levier 14 en un mouvement de translation à la pièce de transmission 8 consiste en une lame épaisse 71 de flexion hors-plan reliée d'une part au bras de levier 14 et d'autre part à la pièce de transmission 8. La forte raideur en compression selon la direction X de cette lame épaisse et longue, permet de transmettre à la pièce de transmission 8 la translation selon la direction X du bras de levier 14 au milieu de la couche MEMS. Même si la lame épaisse de flexion 71 présente une forte épaisseur, sa rotation en flexion autour de la direction hors-plan Z permise par sa finesse selon la direction Y et le faible mouvement de flexion hors plan autour de l'axe de flexion parallèle à la direction Y permettent de faire cohabiter la rotation du bras de levier 14 et la translation de la pièce de transmission 8.

Avantageusement, la lame épaisse 71 de couplage est centrée au-dessus de son axe de flexion pour se rapprocher le plus possible d'une flexion angulaire pure et minimiser sa raideur.

Comme l'axe de flexion de la deuxième liaison 7 apparait au milieu de l'épaisseur MEMS, on obtient bien l'excentricité nécessaire entre la première liaison et la deuxième liaison. La lame épaisse de flexion hors-plan formant la liaison de couplage 7 peut donc être vue comme une biellette connectée entre le bras de levier 14 et la pièce de transmission 8.

De même, comme dans la configuration de l'accéléromètre hors-plan des figures 7A à 7D, la pièce de transmission 8 illustrée est formée par un cadre rectangulaire 81. La pièce de transmission 8 mobile est reliée à deux jauges de contrainte 61, 62 de manière à leur transmettre une force de compression et/ou une force de tension. Les jauges de contrainte 61, 62 sont disposées à l'intérieur du cadre rectangulaire 81 formant la pièce de transmission et sont disposées dans ledit cadre de manière symétrique par rapport à la direction Y. Ainsi les jauges de contrainte sont connectées avec les deux côtés du cadre rectangulaire opposés selon la direction X. Par ailleurs, les jauges de contrainte sont reliées au substrat 2 par des plots d'ancrage 26 disposés à l'intérieur du cadre rectangulaire.

La pièce de transmission 8 est maintenue en translation dans le plan par au moins deux lames épaisses 91, 92 de flexion dans le plan ancrée au substrat par au moins un plot d'ancrage 29, les lames formant la troisième liaison ou liaison glissière 9. Ces lames présentent une forte raideur hors-plan, due à leur forte épaisseur et leur ancrage. De plus, leur forte raideur en compression due à leur forte largueur selon la direction Y permet de bloquer la translation selon cette direction Y. Enfin, leur faible longueur selon la direction X génère une faible raideur dans cette direction X. Cela permet de guider la translation de la pièce de transmission 8 selon la direction X.

La liaison de couplage 7 combinée avec la troisième liaison 9 permet de transformer la rotation du bras de levier 14 autour de la direction Y en une translation de la pièce de transmission 8 selon la direction X.

Comme la pièce de transmission 8 est mobile en translation dans le plan (selon la direction X), les jauges de contrainte ne subissent qu'une compression pure ou une tension pure, sans déformation parasite. Ainsi, la position des jauges est sans conséquence. Il n'y a notamment plus de contrainte de place pour le positionnement des plots d'ancrage des jauges puisque celles-ci peuvent être déportées.

Les figures 12A et 12B illustrent une variante d'un capteur (accéléromètre, gyromètre, dispositif de mesure d'une variation de pression ...) selon l'invention, les moyens de détection 6' étant de type résonateur.

Les figures 12A et 12B illustrent plus précisément lesdits moyens de détection 6' en liaison avec la pièce de transmission 8. Ils comprennent une poutre de résonance 63' reliée à la pièce de transmission. Lorsque la pièce de transmission 8 se déplace selon la direction X, elle compresse ou étire la poutre de résonance 63', modifiant ainsi sa raideur et donc ses modes de déformation. En mettant en mouvement la poutre de résonance par une force électrostatique formée par deux électrodes 66' et 67' et en mesurant la déformation de la poutre grâce aux deux jauges piézorésistives 64' et 65', on peut suivre l'évolution des modes de résonances et en déduire la contrainte appliquée sur la poutre de résonance. On a alors besoin de 3 à 5 plots, ce qui prend beaucoup plus de place qu'une lecture piézorésistive directe. L'invention permet de déporter les jauges par rapport à la pièce mobile pour placer ces plots.

Cette variante s'adapte aux capteurs des différents modes de réalisation et variantes précédemment décrites. Plus généralement, elle s'applique à un capteur selon l'invention.

Dans l'ensemble des modes décrits, par « mince », il faut comprendre de l'ordre de la centaine de nanomètres (nm), et inférieur à quelques micromètres (µm) (NEMS) et par « épais », il faut comprendre entre quelques µm et quelques dizaines de µm (MEMS).

De préférence, l'épaisseur d'une couche mince est comprise entre 100nm et 500nm

De préférence, l'épaisseur d'une couche épaisse est comprise entre 5 et 40 µm, voire entre 10 et 20 µm.

La liaison mécanique et la structure microélectromécanique et/ou nanoélectromécanique de l'invention peut être fabriquée en utilisant les technologies de micro-usinage (et/ou nano-usinage) d'accéléromètres connues, sur du silicium.

Pour réaliser une telle liaison mécanique et une telle structure microélectromécanique et nanoélectromécanique, on peut mettre en oeuvre le procédé général suivant :
- on part d'un silicium sur isolant (SOI) comprenant au moins une couche de substrat en Si, sur laquelle est disposée une première couche d'oxyde de silicium (SiO₂) de quelques centaines de nanomètres à quelques microns servant de première couche sacrificielle lors de la libération des pièces mobiles, et sur la première couche de SiO₂ est disposée une couche mince de silicium monocristallin (NEMS) de quelques centaines de nanomètres à *quelques* microns servant à réaliser les jauges de contraintes ainsi que les lames minces ;
- les motifs de la couche NEMS sont réalisés par photolithographie et gravure pour détourer les jauges de contraintes ainsi que les lames minces ;
- une seconde couche sacrificielle d'oxyde de silicium, elle aussi de quelques centaines de nanomètres à quelques microns, est ensuite déposée. Cette seconde couche de SiO₂ est gravée pour ne rester qu'à certains endroits où elle servira de couche d'arrêt lors de la gravure profonde de la couche épaisse (MEMS) lors de l'étape suivante. Ainsi, la couche NEMS peut être protégée. La seconde couche d'oxyde est détruite lors d'étape de la libération finale ;

- ensuite une étape d'épitaxie de silicium est réalisée, qui permet d'obtenir la couche épaisse (MEMS, quelques microns à quelques dizaines de microns). Cette couche est mise en forme par photolithographie et gravure profonde (Deep Reactive Ion Etching) ;
- enfin, les pièces mobiles sont libérées grâce à la gravure partielle des couches sacrificielles d'oxyde de silicium. On peut notamment exposer la plaque à l'acide fluorhydrique, avantageusement en phase vapeur, pendant une durée contrôlée.

Dans l'ensemble des modes de réalisation, les moyens de détection peuvent comprendre une jauge de contrainte piézorésistive ou piézoélectrique, un résonateur, une capacité ou encore une combinaison desdits moyens ... Avantageusement, ils peuvent comprendre au moins deux jauges de contraintes, deux résonateurs ou deux capacités de manière à réaliser une mesure différentielle.

Dans le cas où on a un système capacitif avec une électrode en translation, la pièce de transmission peut être remplacée par l'électrode en translation directement. Dans ce cas, la troisième liaison de type liaison glissière est configurée pour guider l'électrode en translation selon la direction de translation dans le plan, et non la pièce de transmission qui peut être supprimée.

Dans l'ensemble des modes de réalisation, la pièce mobile peut être une masse mobile, un bras de levier ou toute autre pièce adaptée. Un bras de levier peut être soit une partie de masse mobile, soit relié à une masse mobile, à une membrane ou un piston, ou plus généralement à une partie mobile dont on cherche à mesurer le mouvement. La pièce mobile peut être recouverte de matériau magnétique pour réaliser un magnétomètre.

La liaison mécanique selon la présente invention peut être appliquée à l'ensemble des structures MEMS-NEMS présentant un mouvement de rotation d'une pièce mobile par rapport à une pièce fixe, généralement un substrat.

Une telle structure MEMS-NEMS peut être utilisée pour des capteurs à détection hors-plan comme les accéléromètres, les capteurs de pression, les microphones, les gyromètres, les magnétomètres, ou pour des capteurs à détection dans le plan comme des accéléromètres, gyromètres, magnétomètres, microphones ...

Les différents modes et variantes présentés peuvent être combinés entre eux.

En outre, la présente invention n'est pas limitée aux modes de réalisation précédemment décrits mais s'étend à tout mode de réalisation entrant dans la portée des revendications.

## Revendications

1. Liaison mécanique (1) pour une structure microélectromécanique et/ou nanoélectromécanique, ladite structure comprenant une pièce mobile (4, 14, 41), une pièce fixe (2) s'étendant selon un plan principal (OXY) et des moyens de détection (6, 61, 62, 6') du déplacement de la pièce mobile (4, 14) par rapport à la pièce fixe (2), ladite liaison mécanique comprenant :
- une première liaison (5, 5', 5") reliée à la pièce fixe (2) et à la pièce mobile (4, 14) et apte à autoriser la rotation de ladite pièce mobile par rapport à ladite pièce fixe autour d'un axe de rotation (Y5, Y5', Z5);
ladite liaison mécanique étant **caractérisée en ce qu'**elle comprend en outre :
- une deuxième liaison (7, 7', 7") connectant la pièce mobile (4, 14) aux moyens de détection (6, 61, 62, 6') à une distance donnée (l_{exc}) par rapport à l'axe de rotation (Y5, Y5', Z5) selon une direction perpendiculaire audit axe de rotation ;
- une troisième liaison (9, 9') reliée à la pièce fixe (2) et aux moyens de détection et configurée pour guider lesdits moyens de détection selon une direction de translation (X) dans le plan de la pièce fixe (2) ;
de sorte que la combinaison de la deuxième liaison (7, 7', 7") et de la troisième liaison (9, 9') soit apte à transformer le mouvement de rotation de la pièce mobile (4, 14) en un mouvement de translation des moyens de détection selon la direction de translation (X) dans le plan principal (OXY) de la pièce fixe (2).

2. Liaison mécanique (1) selon la revendication 1 comprenant en outre une pièce de transmission (8, 8') reliée aux moyens de détection (6, 61, 62, 6'), la deuxième liaison (7, 7', 7") étant reliée à la pièce mobile (4, 14) et à la pièce de transmission (8, 8').

3. Liaison mécanique (1) selon la revendication 1 ou 2 **caractérisée en ce que** la première liaison (5, 5') est une liaison pivot hors-plan par rapport au plan (OXY) de la pièce fixe (2) et **en ce qu'**elle comprend au moins une première lame (51, 51') destinée à travailler en torsion autour d'un axe de rotation (Y5, Y5') et/ou au moins une deuxième lame (52, 52') destinée à travailler en flexion autour de l'axe de rotation (Y5, Y5'), chacune des première et seconde lames étant reliées d'une part à la pièce mobile (4, 14), et d'autre part à la pièce fixe (2) par exemple à l'aide d'au moins un plot d'ancrage (25).

4. Liaison mécanique (1) selon la revendication 3 **caractérisée en ce que** la au moins une première lame (51, 51') est une lame épaisse.

5. Liaison mécanique (1) selon l'une quelconque des revendications 3 ou 4 **caractérisée en ce que** la au moins une seconde lame (52) est une lame mince.

6. Liaison mécanique (1) selon l'une quelconque des revendications 3 ou 4 **caractérisée en ce que** la au moins une seconde lame (52') est une lame épaisse.

7. Liaison mécanique (1) selon l'une des revendications 3 à 6 **caractérisée en ce que** la deuxième liaison (7) comprend une lame épaisse (71) de flexion hors-plan s'étendant selon la direction de translation (X).

8. Liaison mécanique (1) selon l'une des revendications 3 à 6 **caractérisée en ce que** la deuxième liaison (7') comprend au moins une lame mince (71') de flexion hors-plan s'étendant selon la direction de translation (X).

9. Liaison mécanique (1) selon la revendication 1 ou 2 **caractérisée en ce que** la première liaison (5") est une liaison pivot dans le plan (OXY) de la pièce fixe (2) et **en ce qu'**elle comprend au moins deux lames épaisses de flexion (51", 52") dans le plan non colinéaires et configurées de manière à ce que l'intersection des desdites lames épaisses forme une liaison pivot dans le plan selon un axe de rotation (Z5) perpendiculaire au plan du substrat (OXY).

10. Liaison mécanique (1) selon la revendication 9 **caractérisée en ce que** la deuxième liaison (7") comprend une lame épaisse (71") de flexion dans le plan s'étendant selon la direction de translation (X).

11. Liaison mécanique (1) selon l'une des revendications 2 à 10 **caractérisée en ce que** la pièce de transmission (8, 8') est formée par un cadre épais (81, 81'), par exemple un cadre à base rectangulaire ou carrée formé par quatre poutres épaisses reliées entre elles le long de leur épaisseur.

12. Liaison mécanique (1) selon la revendication 11 **caractérisée en ce que** la pièce de transmission (8') comprend en outre une poutre centrale (85') s'étendant selon la direction de rotation (Y) et disposée sensiblement au milieu du cadre épais (81').

13. Liaison mécanique (1) selon l'une des revendications précédentes **caractérisée en ce que** la troisième liaison (9) comprend au moins une lame épaisse (91) de flexion dans le plan principal (OXY), fine selon la direction de translation (X) et reliée d'une part à la pièce fixe (2), par exemple par au moins un plot d'ancrage (29) et d'autre part aux moyens de détection (6, 61, 62, 6') ou à la pièce de transmission (8, 8').

14. Liaison mécanique (1) selon l'une des revendications 1 à 12 **caractérisée en ce que** la troisième liaison (9') comprend au moins une double lame épaisse (91') de flexion dans le plan (OXY), ladite double lame épaisse comprenant une première lame épaisse (911') reliée aux moyens de détection (6, 61, 62, 6') ou à la pièce de transmission (8, 8'), une seconde lame épaisse (912') reliée à la pièce fixe (2), par exemple par au moins un plot d'ancrage (29) et une pièce de liaison intermédiaire (913') reliant les première et seconde lames épaisses (911') et (912').

15. Structure microélectromécanique et/ou nanoélectromécanique comprenant une pièce mobile (4, 14), une pièce fixe (2) s'étendant selon un plan (OXY), des moyens de détection (6, 61, 62, 6') du déplacement de la pièce mobile (4, 14) par rapport à la pièce fixe (2) et une liaison mécanique (1) selon l'une des revendications 1 à 14, ladite liaison mécanique étant configurée pour relier la pièce mobile (4, 14) et les moyens de détection (6, 61, 62, 6'), lesdits moyens de détection étant disposés de façon à mesurer le déplacement en translation selon la direction de translation (X).

16. Structure microélectromécanique et/ou nanoélectromécanique selon la revendication 15 **caractérisée en ce que** les moyens de détection (6, 6') comprennent au moins une jauge de contrainte (61) de type piézorésistive ou piézoélectrique, une poutre de résonance (63'), une capacité ou une combinaison desdits moyens.

17. Structure microélectromécanique et/ou nanoélectromécanique selon l'une des revendications 15 ou 16 **caractérisée en ce que** les moyens de détection (6) comprennent deux jauges de contrainte (61, 62).

18. Structure microélectromécanique et/ou nanoélectromécanique selon l'une des revendications 15 à 17, la liaison mécanique (1) comprenant une pièce de transmission (8, 8') reliée aux moyens de détection (6, 61, 62, 6'), la deuxième liaison (7, 7', 7") étant reliée à la pièce mobile (4, 14) et à la pièce de transmission (8, 8').

19. Structure microélectromécanique et/ou nanoélectromécanique selon la revendication 18, les moyens de détection (6, 61, 62) étant disposés à l'intérieur de la pièce de transmission (8, 8').

20. Dispositif de mesure d'une variation de pression comprenant une structure microélectromécanique et/ou nanoélectromécanique selon l'une des revendications 15 à 19, comprenant une membrane (40) ou un piston relié(e) à un bras de levier (14) formant la pièce mobile.

21. Accéléromètre comprenant une structure microélectromécanique et/ou nanoélectromécanique selon l'une des revendications 15 à 19, comprenant une masse (4) formant la pièce mobile ou un bras de levier formant la pièce mobile.

## Patentansprüche

1. Mechanische Verbindung (1) für eine mikroelektromechanische und/oder nanoelektromechanische Struktur, wobei die Struktur ein bewegliches Teil (4, 14, 41), ein festes Teil (2), das sich entlang einer Hauptebene (OXY) erstreckt, und Detektionsmittel (6, 61, 62, 6') zum Detektieren der Verschiebung des beweglichen Teils (4, 14) in Bezug auf das feste Teil (2) umfasst, wobei die mechanische Verbindung Folgendes umfasst:
- eine erste Verbindung (5, 5', 5"), die mit dem feststehenden Teil (2) und dem beweglichen Teil (4, 14) verbunden ist und in der Lage ist, die Drehung des beweglichen Teils in Bezug auf das feste Teil um eine Drehachse (Y5, Y5', Z5) zuzulassen;
wobei die mechanische Verbindung **dadurch gekennzeichnet ist, dass** sie ferner Folgendes umfasst:
- eine zweite Verbindung (7, 7', 7"), die das bewegliche Teil (4, 14) mit den Detektionsmitteln (6, 61, 62, 6') in einem gegebenen Abstand (l_{exc}) von der Drehachse (Y5, Y5', Z5) entlang einer Richtung senkrecht zu der Drehachse verbindet;
- eine dritte Verbindung (9, 9'), die mit dem feststehenden Teil (2) und den Detektionsmitteln verbunden und so konfiguriert ist, dass sie die Detektionsmittel entlang einer Translationsrichtung (X) in der Ebene des feststehenden Teils (2) führt;
sodass die Kombination der zweiten Verbindung (7, 7', 7") und der dritten Verbindung (9, 9') in der Lage ist, die Drehbewegung des beweglichen Teils (4, 14) in eine Translationsbewegung der Detektionsmittel entlang der Translationsrichtung (X) in der Hauptebene (OXY) des feststehenden Teils (2) umzuwandeln.

2. Mechanische Verbindung (1) nach Anspruch 1, ferner umfassend ein Übertragungsteil (8, 8'), das mit den Detektionsmitteln (6, 61, 62, 6') verbunden ist, wobei die zweite Verbindung (7, 7', 7") mit dem beweglichen Teil (4, 14) und mit dem Übertragungsteil (8, 8') verbunden ist.

3. Mechanische Verbindung (1) nach Anspruch 1 oder 2, **dadurch gekennzeichnet, dass** die erste Verbindung (5, 5') eine aus der Ebene (OXY) des feststehenden Teils (2) herausragende Schwenkverbindung ist und dass sie mindestens ein erstes Blatt (51, 51') umfasst, das dazu bestimmt ist, in Torsion um eine Drehachse (Y5, Y5') zu arbeiten und/oder mindestens ein zweites Blatt (52, 52'), das dazu bestimmt ist, in Biegung um die Drehachse (Y5, Y5') zu arbeiten, wobei jedes des ersten und des zweiten Blattes einerseits mit dem beweglichen Teil (4, 14) und andererseits mit dem feststehenden Teil (2) beispielsweise mit Hilfe von mindestens einem Verankerungsklotz (25) verbunden ist.

4. Mechanische Verbindung (1) nach Anspruch 3, **dadurch gekennzeichnet, dass** das mindestens eine erste Blatt (51, 51') ein dickes Blatt ist.

5. Mechanische Verbindung (1) nach einem der Ansprüche 3 oder 4, **dadurch gekennzeichnet, dass** das mindestens eine zweite Blatt (52) ein dünnes Blatt ist.

6. Mechanische Verbindung (1) nach einem der Ansprüche 3 oder 4, **dadurch gekennzeichnet, dass** das mindestens eine zweite Blatt (52') eine dickes Blatt ist.

7. Mechanische Verbindung (1) nach einem der Ansprüche 3 bis 6, **dadurch gekennzeichnet, dass** die zweite Verbindung (7) ein dickes, aus der Ebene herausragendes Biegungsblatt (71) umfasst, das sich entlang der Translationsrichtung (X) erstreckt.

8. Mechanische Verbindung (1) nach einem der Ansprüche 3 bis 6, **dadurch gekennzeichnet, dass** die zweite Verbindung (7') mindestens ein dünnes, aus der Ebene herausragendes Biegungsblatt (71') umfasst, das sich entlang der Translationsrichtung (X) erstreckt.

9. Mechanische Verbindung (1) nach Anspruch 1 oder 2, **dadurch gekennzeichnet, dass** die erste Verbindung (5") eine Schwenkverbindung in der Ebene (OXY) des feststehenden Teils (2) ist und dass sie mindestens zwei dicke Biegungsblätter (51", 52") in der Ebene umfasst, die nicht kollinear sind und so konfiguriert sind, dass der Schnittpunkt der dicken Blätter eine Schwenkverbindung in der Ebene entlang einer Drehachse (Z5) bildet, die senkrecht zur Ebene des Substrats (OXY) verläuft.

10. Mechanische Verbindung (1) nach Anspruch 9, **dadurch gekennzeichnet, dass** die zweite Verbindung (7") ein dickes Biegungsblatt (71") in der Ebene umfasst, die sich entlang der Translationsrichtung (X) erstreckt.

11. Mechanische Verbindung (1) nach einem der Ansprüche 2 bis 10, **dadurch gekennzeichnet, dass** das Übertragungsteil (8, 8') durch einen dicken Rahmen (81, 81') gebildet wird, beispielsweise einen Rahmen mit rechteckiger oder quadratischer Grundfläche, der durch vier dicke Balken gebildet wird, die entlang ihrer Dicke miteinander verbunden sind.

12. Mechanische Verbindung (1) nach Anspruch 11, **dadurch gekennzeichnet, dass** das Übertragungsteil (8') ferner einen Mittelbalken (85') umfasst, der sich entlang der Drehrichtung (Y) erstreckt und im Wesentlichen in der Mitte des dicken Rahmens (81') angeordnet ist.

13. Mechanische Verbindung (1) nach einem der vorhergehenden Ansprüche, **dadurch gekennzeichnet, dass** die dritte Verbindung (9) mindestens ein dickes Biegungsblatt (91) zur Biegung in der Hauptebene (OXY) umfasst, das in der Translationsrichtung (X) dünn ist und einerseits mit dem feststehenden Teil (2), beispielsweise durch mindestens einen Verankerungsklotz (29), und andererseits mit den Detektionsmitteln (6, 61, 62, 6') oder dem Übertragungsteil (8, 8') verbunden ist.

14. Mechanische Verbindung (1) nach einem der Ansprüche 1 bis 12, **dadurch gekennzeichnet, dass** die dritte Verbindung (9') mindestens ein doppeltes dickes Biegungsblatt (91') in der Ebene (OXY) umfasst, wobei das doppelte dicke Blatt ein erstes dickes Blatt (911') umfasst, das mit den Detektionsmitteln (6, 61, 62, 6') oder mit dem Übertragungsteil (8, 8') verbunden ist, ein zweites dickes Blatt (912'), das mit dem feststehenden Teil (2) verbunden ist, zum Beispiel durch mindestens einen Verankerungsklotz (29), und ein Zwischenverbindungsteil (913'), welches das erste und das zweite dicke Blatt (911') und (912') verbindet.

15. Mikroelektromechanische und/oder nanoelektromechanische Struktur, umfassend ein bewegliches Teil (4, 14), ein feststehendes Teil (2), das sich entlang einer Ebene (OXY) erstreckt, Detektionsmittel (6, 61, 62, 6') der Verschiebung des beweglichen Teils (4, 14) in Bezug auf das feststehende Teil (2) und eine mechanische Verbindung (1) nach einem der Ansprüche 1 bis 14, wobei die mechanische Verbindung so konfiguriert ist, dass sie das bewegliche Teil (4, 14) und die Detektionsmittel (6, 61, 62, 6') verbindet, wobei die Detektionsmittel so angeordnet sind, dass sie die Translationsverschiebung entlang der Translationsrichtung (X) messen.

16. Mikroelektromechanische und/oder nanoelektromechanische Struktur nach Anspruch 15, **dadurch gekennzeichnet, dass** die Detektionsmittel (6, 6') mindestens einen Dehnungsmessstreifen (61) vom piezoresistiven oder piezoelektrischen Typ, einen Resonanzbalken (63'), eine Kapazität oder eine Kombination der genannten Mittel umfassen.

17. Mikroelektromechanische und/oder nanoelektromechanische Struktur nach einem der Ansprüche 15 oder 16, **dadurch gekennzeichnet, dass** die Detektionsmittel (6) zwei Dehnungsmessstreifen (61, 62) umfassen.

18. Mikroelektromechanische und/oder nanoelektromechanische Struktur nach einem der Ansprüche 15 bis 17, wobei die mechanische Verbindung (1) ein Übertragungsteil (8, 8') umfasst, das mit den Detektionsmitteln (6, 61, 62, 6') verbunden ist, wobei die zweite Verbindung (7, 7', 7") mit dem beweglichen Teil (4, 14) und mit dem Übertragungsteil (8, 8') verbunden ist.

19. Mikroelektromechanische und/oder nanoelektromechanische Struktur nach Anspruch 18, wobei die Sensormittel (6, 61, 62) im Inneren des Übertragungsteils (8, 8') angeordnet sind.

20. Vorrichtung zum Messen einer Druckänderung, umfassend eine mikroelektromechanische und/oder nanoelektromechanische Struktur nach einem der Ansprüche 15 bis 19, umfassend eine Membran (40) oder einen Kolben, die/der mit einem Hebelarm (14) verbunden ist, der das bewegliche Teil bildet.

21. Beschleunigungsmesser, umfassend eine mikroelektromechanische und/oder nanoelektromechanische Struktur nach einem der Ansprüche 15 bis 19, umfassend eine Masse (4), die das bewegliche Teil bildet, oder einen Hebelarm, der das bewegliche Teil bildet.

## Claims

1. A mechanical link (1) for a microelectromechanical and/or nanoelectromechanical structure, said structure comprising a mobile component (4, 14, 41), a fixed component (2) extending on a main plane (OXY) and means (6, 61, 62, 6') for detecting the displacement of the mobile component (4, 14) relative to the fixed component (2), said mechanical link comprising:
- a first link (5, 5', 5") linked to the fixed component (2) and to the mobile component (4, 14) and capable of allowing the rotation of said mobile component relative to said fixed component about an axis of rotation (Y5, Y5', Z5);
said mechanical link being **characterised in that** it further comprises:
- a second link (7, 7', 7") connecting the mobile component (4, 14) to the detection means (6, 61, 62, 6') at a given distance (l_{exc}) relative to the axis of rotation (Y5, Y5', Z5) in a direction perpendicular to said axis of rotation;
- a third link (9, 9') linked to the fixed component (2) and to the detection means and configured to guide said detection means in a direction of translation (X) in the plane of the fixed component (2);
such that the combination of the second link (7, 7', 7") and of the third link (9, 9') is capable of transforming the rotational movement of the mobile component (4, 14) into a translational movement of the detection means in the direction of translation (X) in the main plane (OXY) of the fixed component (2).

2. The mechanical link (1) according to claim 1, further comprising a transmission component (8, 8') linked to the detection means (6, 61, 62, 6'), the second link (7, 7', 7") being linked to the mobile component (4, 14) and to the transmission component (8, 8').

3. The mechanical link (1) according to claim 1 or 2, **characterised in that** the first link (5, 5') is an out-of-plane pivot link relative to the plane (OXY) of the fixed component (2) and **in that** it comprises at least one first blade (51, 51') intended to work by torsion about an axis of rotation (Y5, Y5') and/or at least one second blade (52, 52') intended to work by bending about the axis of rotation (Y5, Y5'), each of the first and second blades being linked on one side to the mobile component (4, 14), and on the other side to the fixed component (2), for example using at least one anchoring block (25).

4. The mechanical link (1) according to claim 3, **characterised in that** the at least one first blade (51, 5 1') is a thick blade.

5. The mechanical link (1) according to any one of claims 3 or 4, **characterised in that** the at least one second blade (52) is a thin blade.

6. The mechanical link (1) according to any one of claims 3 or 4, **characterised in that** the at least one second blade (52') is a thick blade.

7. The mechanical link (1) according to one of claims 3 to 6, **characterised in that** the second link (7) comprises a thick out-of-plane bending blade (71) extending in the direction of translation (X).

8. The mechanical link (1) according to one of claims 3 to 6, **characterised in that** the second link (7') comprises at least one thin out-of-plane bending blade (71') extending in the direction of translation (X).

9. The mechanical link (1) according to claim 1 or 2, **characterised in that** the first link (5") is a pivot link in the plane (OXY) of the fixed component (2) and **in that** it comprises at least two thick in-plane bending blades (51", 52") that are non-colinear and configured so that the intersection of said thick blades forms a pivot link in the plane on an axis of rotation (Z5) perpendicular to the plane of the substrate (OXY).

10. The mechanical link (1) according to claim 9, **characterised in that** the second link (7") comprises a thick in-plane bending blade (71") extending in the direction of translation (X).

11. The mechanical link (1) according to one of claims 2 to 10, **characterised in that** the transmission component (8, 8') is formed by a thick frame (81, 81'), for example a frame with rectangular or square base formed by four thick beams linked to one another along their thickness.

12. The mechanical link (1) according to claim 11, **characterised in that** the transmission component (8') further comprises a central beam (85') extending in the direction of rotation (Y) and disposed substantially in the middle of the thick frame (81').

13. The mechanical link (1) according to one of the preceding claims, **characterised in that** the third link (9) comprises at least one thick blade (91) for bending in the main plane (OXY), which is fine in the direction of translation (X) and linked on one side to the fixed component (2), for example by at least one anchoring block (29), and on the other side to the detection means (6, 61, 62, 6') or to the transmission component (8, 8').

14. The mechanical link (1) according to one of claims 1 to 12, **characterised in that** the third link (9') comprises at least one thick double blade (91') for bending in the plane (OXY), said thick double blade comprising a first thick blade (911') linked to the detection means (6, 61, 62, 6') or to the transmission component (8, 8'), one second thick blade (912') linked to the fixed component (2), for example by at least one anchoring block (29) and one intermediate link component (913') linking the first and second thick blades (911') and (912').

15. A microelectromechanical and/or nanoelectromechanical structure comprising a mobile component (4, 14), a fixed component (2) extending on a plane (OXY), detection means (6, 61, 62, 6') for detecting the displacement of the mobile component (4, 14) relative to the fixed component (2) and a mechanical link (1) according to one of claims 1 to 14, said mechanical link being configured to link the mobile component (4, 14) and the detection means (6, 61, 62, 6'), said detection means being disposed so as to measure the translational displacement in the direction of translation (X).

16. The microelectromechanical and/or nanoelectromechanical structure according to claim 15, **characterised in that** the detection means (6, 6') comprise at least one strain gauge (16) of piezoresistive or piezoelectric type, a resonance beam (63'), a capacitance or a combination of said means.

17. The microelectromechanical and/or nanoelectromechanical structure according to one of claims 15 or 16, **characterised in that** the detection means (6) comprise two strain gauges (61, 62).

18. The microelectromechanical and/or nanoelectromechanical structure according to one of claims 15 to 17, the mechanical link (1) comprising a transmission component (8, 8') linked to the detection means (6, 61, 62, 6'), the second link (7, 7', 7") being linked to the mobile component (4, 14) and to the transmission component (8, 8').

19. The microelectromechanical and/or nanoelectromechanical structure according to claim 18, the detection means (6, 61, 62) being disposed inside the transmission component (8, 8').

20. A device for measuring a pressure variation comprising a microelectromechanical and/or nanoelectromechanical structure according to one of claims 15 to 19, comprising a membrane (40) or a piston linked to a lever arm (14) forming the mobile component.

21. An accelerometer comprising a microelectromechanical and/or nanoelectromechanical structure according to one of claims 15 to 19, comprising a mass (4) forming the mobile component or a lever arm forming the mobile component.
